(19) Europäisches Patentamt

European Patent Office

Office européen des brevets

(11) **EP 1 160 400 B1**

(12) **FASCICULE DE BREVET EUROPEEN**

(45) Date de publication et mention
de la délivrance du brevet:
**02.03.2005 Bulletin 2005/09**

(51) Int Cl.⁷: **E05B 49/00**, H03K 17/96

(21) Numéro de dépôt: **01440153.3**

(22) Date de dépôt: **01.06.2001**

(54) **Dispositif de commutation fonctionnant par contact d'un corps humain**

Mit Kontakt eines menschlichen Körpers arbeitende Schaltvorrichtung

Switching device operating by contact of human body

(84) Etats contractants désignés:
**DE ES FR GB IT SE**

(30) Priorité: **02.06.2000 FR 0007098**
**06.11.2000 FR 0014210**

(43) Date de publication de la demande:
**05.12.2001 Bulletin 2001/49**

(73) Titulaire: **Delphi Technologies, Inc.**
**Troy, MI 48007 (US)**

(72) Inventeur: **Stricker, Jean-Mathieu**
**67610 La Wantzenau (FR)**

(74) Mandataire: **Littolff, Denis**
**Meyer & Partenaires,**
**Conseils en Propriété Industrielle,**
**Bureaux Europe,**
**20, place des Halles**
**67000 Strasbourg (FR)**

(56) Documents cités:
**EP-A- 0 955 431        WO-A-97/41322**
**DE-A- 4 132 036        FR-A- 2 271 538**
**FR-A- 2 771 534        FR-A- 2 785 703**
**US-A- 4 758 735        US-A- 4 891 627**

## Description

La présente invention concerne un dispositif de commutation changeant d'état en réponse à un contact de la main, ou plus généralement d'une partie du corps humain. Selon un exemple d'application préférentiel, facilitant au surplus l'explication de l'invention, ledit dispositif de commutation peut servir au verrouillage / déverrouillage automatisé d'au moins une porte d'un véhicule automobile, et est alors disposé sur au moins une portion prédéterminée de la structure du véhicule.

Actuellement, dans la plupart des cas, les utilisateurs de véhicules équipés d'un système de verrouillage / déverrouillage centralisé disposent d'un boîtier émetteur capable de réaliser alternativement le verrouillage ou le déverrouillage, selon le cas, à distance. Ledit boîtier comporte un bouton qui, lorsqu'il est activé, permet l'émission d'un signal d'identification à l'adresse de la centrale électronique du véhicule.

Le récepteur situé dans ladite centrale effectue le test de correspondance avec le code d'identification mémorisé et génère s'il y lieu un message d'automatisation pour l'ouverture ou la fermeture des verrous.

Ce système fonctionne par conséquent avec un émetteur porté par l'utilisateur du véhicule, et un récepteur contenu dans ce dernier. Il implique que ledit utilisateur réalise une manoeuvre manuelle sur le boîtier, et donc qu'il ait celui-ci à portée de main. De plus, l'existence de ce bouton, impliquant une opération active de la part de l'utilisateur, transforme le boîtier en un composant actif, manipulable, et donc plus compliqué à fabriquer et sujet à une certaine usure, voire à des dysfonctionnements.

On connaît également des systèmes dans lesquels l'élément externe au véhicule, porté par l'utilisateur, est modifié pour le rendre totalement passif et donc en principe beaucoup plus fiable. Ce composant n'étant alors par définition plus manipulé, sa durée de vie est en théorie illimitée. De plus, les parties mécaniques y étant supprimées, ledit composant présente un prix de revient inférieur à ses devanciers et il est plus économique à fabriquer.

De tels dispositifs de déverrouillage automatisés se présentent de la manière suivante : ils comportent un commutateur répercutant une action de l'utilisateur sur une poignée du véhicule, connecté à un circuit détectant la commutation, ledit circuit émettant dès détection de la commutation un signal à destination d'un boîtier passif muni d'un émetteur-récepteur renvoyant à réception un signal d'identification autorisant la commande du système électronique de verrouillage / déverrouillage central des portes du véhicule, préférentiellement en vue du déverrouillage.

Ce système est basé sur un couple d'émetteurs / récepteurs permettant en fait à la centrale électronique interne au véhicule d'initier la liaison par l'envoi d'un premier message, auquel le composant strictement passif détenu par l'utilisateur de la voiture répond, le déclenchement du processus étant mécanique.

En l'absence de réponse, indiquant que la personne responsable du contact sur le véhicule ne détient pas ledit composant, aucun ordre de déverrouillage n'est évidemment donné, et le véhicule reste fermé. À l'inverse, si l'utilisateur potentiel porte le composant adéquat, celui qui est programmé pour le véhicule, un message correct - électroniquement vérifié - est renvoyé, et le déverrouillage est autorisé par la centrale du véhicule.

Ces commutateurs comportent des contacts mécaniques situés dans les poignées ou dans les boutons d'ouverture des coffres et portes. Lesdits contacts détectent en fait le début du mouvement d'ouverture.

Les parties mécaniques desdits commutateurs présentent cependant sensiblement les mêmes limitations et inconvénients que dans les boîtiers manuels précités : les parties mobiles sont sujettes à usure, voire à rupture, elles sont économiquement coûteuses à l'installation et/ou à la fabrication, elles nécessitent dans certains cas un calibrage, etc... Ces parties sont de plus sensibles à certains paramètres environnementaux tels que l'humidité ambiante, les projections d'eau, la poussière ... également susceptibles de provoquer des dysfonctionnements du système de verrouillage / déverrouillage.

La présente invention remédie à ces inconvénients, en proposant un dispositif de commutation à vocation multiple qui change d'état en réponse à un contact de la main ou d'une partie du corps, par exemple de l'utilisateur d'un véhicule sur une portion prédéterminée de la structure de celui-ci, comportant notamment un capteur capacitif reflétant l'existence dudit contact, connecté à un circuit de traitement de la variation d'une grandeur électrique variable mesurée par ledit capteur délivrant une impulsion au moment du contact.

Selon l'invention, ledit circuit de traitement comporte successivement les étages suivants :

- un oscillateur convertisseur des variations de capacité en variations de fréquence ;
- un convertisseur convertissant les variations de fréquence en variations de tension ;
- un filtre passe-haut ou différentiateur ;
- un amplificateur de tension ; et
- un déclencheur monostable produisant un signal de sortie sous forme d'impulsions.

Ce dispositif de commutation peut par exemple être aisément mis en oeuvre pour piloter le verrouillage / déverrouillage des portes d'un véhicule, qui n'est alors plus basé sur un système mécanique.

Le signal de sortie de ce circuit de traitement reflète donc la variation de la capacité du capteur. Selon le cas, comme cela sera expliqué plus en détail dans la suite, ladite variation de capacité est transformée par le circuit en une variation d'une autre grandeur électrique qui est alors traitée par la centrale électronique du véhicule.

Ce détecteur capacitif présente l'avantage d'anticiper l'intention de l'utilisateur par rapport à un contact mécanique, en ce sens qu'un simple effleurement du capteur est suffisant, sans qu'il soit nécessaire d'actionner un organe mobile. Le gain de temps pour la détection, par rapport aux commutateurs mécaniques, est supérieur à 50 ms. Un tel capteur n'a évidemment pas de partie mobile, et il est donc de plus largement indépendant des variations environnementales.

De préférence encore, ledit capteur capacitif consiste en une simple plaquette métallique fixée en au moins un endroit d'une structure capacitive dotée d'éléments pilotables par commutation, par exemple la structure métallique d'un véhicule munie d'organes de verrouillage des portes et ouvertures.

Cette plaquette métallique est isolée de ladite structure par une couche isolante d'épaisseur non négligeable, permettant de maintenir sa capacité à une valeur minimale.

Par rapport à d'autres détecteurs capacitifs, de façon extrêmement avantageuse, celui de l'invention n'est sensible qu'aux variations de capacité, et 1 ne nécessite aucun calibrage ou ajustement.

L'invention repose en effet sur l'établissement d'un circuit pratiquement purement capacitif entre le capteur, la structure capacitive et le corps de l'utilisateur. Celui-ci présente de fait une liaison électrique capacitive avec le sol, du fait de l'existence des chaussures, et plus particulièrement des semelles. De même, dans l'exemple du véhicule, ce demier est séparé du sol par les pneus et présente également une liaison capacitive avec le sol. Lorsque l'utilisateur entre en contact avec le véhicule, par exemple par manipulation d'une poignée de portière munie d'un tel capteur, les deux capacités se connectent en parallèle, et les valeurs des capacités se modifient par conséquent.

La capacité du véhicule par rapport à la terre est évidemment bien supérieure à celle du corps humain. Pour l'établissement d'un circuit électronique intégré au véhicule pour la détection d'une variation de capacité, la référence électrique est bien entendu ledit véhicule, ou plus exactement sa structure métallique capacitive.

Dans cette optique, les capacités respectives du véhicule et du corps humain sont vues par un circuit de traitement lié au véhicule comme étant connectées en série. La liaison entre la plaquette métallique et la structure métallique du véhicule, également capacitive, représente le capteur capacitif précité, et est alors vu comme disposé en parallèle aux capacités précitées connectées en série.

La capacité équivalente ($C_e$) à l'entrée du circuit de traitement est donc :

$$C_e = \frac{C_v \cdot C_b}{C_v \cdot C_b} + C_s$$

avec :

- $C_v$ = capacité du véhicule ;
- $C_b$ = capacité du corps humain ; et
- $C_s$ = capacité "parasite" du capteur par rapport à la structure du véhicule.

La capacité $C_v$ étant très supérieure à $C_b$, la formule (1) devient :

$$C_e = C_b + C_s$$

En l'absence de contact, le circuit de détection ne voit que $C_s$.

Pour que la détection du contact puisse se faire dans de bonnes conditions, il importe que la valeur de $C_s$ soit maintenue la plus basse possible, comme on l'a mentionné auparavant, d'où les mesures d'isolation, afin que la détection du contact, et donc de l'ajout de la capacité $C_b$, ne nécessitent pas une trop grande sensibilité.

Idéalement, la variation due à l'établissement du contact doit être au moins supérieure à 30%.

De préférence, la plaquette métallique constituant le capteur capacitif est fixée au véhicule au niveau des poignées externes des portières, ou plus généralement au voisinage des mécanismes d'ouverture des portes, coffre, etc.

Selon une possibilité applicable au circuit électronique de traitement de l'invention, l'oscillateur convertisseur de capacité en fréquence est basé sur un inverseur logique à hystérésis dont l'entrée et la sortie sont reliées par une résistance de réglage de la fréquence.

Cette résistance agit sur la réaction de l'oscillateur : plus la résistance diminue, plus la fréquence augmente. L'autre élément de cet oscillateur est la plaque de détection dont la capacité par rapport à la masse dépend notamment de l'environnement et de la proximité du corps humain (présence de la main). L'oscillateur fonctionne selon un mode expliqué plus en détail ci-après.

Secondairement, l'entrée de l'inverseur et le capteur capacitif sont reliés via une résistance, ladite entrée étant en outre connectée à la tension d'alimentation et à la masse via deux diodes de protection qui ne deviennent passantes qu'en cas de décharges électrostatiques. Ces composants protègent l'entrée de la porte logique contre les éventuelles surtensions et décharges électrostatiques.

Selon une possibilité, le convertisseur fréquence / tension est constitué d'une première capacité de liaison, couplée à un redresseur comportant deux diodes et une capacité de filtrage. Il s'agit d'un redresseur simple alternance.

Le principe de ce convertisseur, expliqué plus en détail dans la suite, est basé sur la variation d'impédance du condensateur en fonction de la fréquence. Le redresseur réalise ensuite la conversion de fréquence en tension.

De préférence, une résistance est disposée en parallèle à la capacité.

Cette résistance a pour fonction de filtrer la tension redressée, en association avec le condensateur du redresseur, avec une constante de temps permettant de détecter très rapidement le contact du corps sur le capteur.

De préférence encore, le filtre passe-haut est constitué d'une capacité (C3) connectée en série à une résistance.

Pour ne pas influencer l'étage de filtrage précédent, cette dernière résistance et celle de l'étage précédent sont dans un rapport d'au moins 5.

Selon une configuration possible, l'étage amplificateur de tension comporte une porte inverseuse associée à une boucle de contre-réaction constituée d'une résistance et d'une capacité en parallèle.

Cet amplificateur procure un gain en tension stable et il consomme un faible courant d'alimentation.

Toujours selon une configuration électronique possible, le déclencheur monostable est ensuite constitué d'un transistor dont la base est connectée à une capacité, et le collecteur est relié à un inverseur logique à hystérésis.

Il sert à fournir une impulsion de durée fixe lorsque la main entre en contact avec la plaque détectrice.

De préférence, la sortie de l'amplificateur de tension est reliée à la capacité via une résistance. Cette résistance a pour fonction de limiter le courant de charge.

Une autre résistance est disposée en sortie de la capacité, en parallèle à la jonction base-émetteur du transistor. Elle sert à charger la capacité couplée à la base.

Dans l'hypothèse de l'application de invention au verrouillage / déverrouillage des portes d'un véhicule, et plus particulièrement pour la deuxième fonction, le circuit électronique de traitement est connecté à un émetteur-récepteur lié au véhicule (V), émettant dès détection du contact un signal radiofréquence à destination d'un transpondeur manuel comportant un émetteur-récepteur, ledit transpondeur renvoyant à réception un signal d'identification autorisant la commande du système électronique de verrouillage / déverrouillage central des portes du véhicule (V).

L'invention, et notamment le circuit électronique de traitement, va à présent être décrite plus en détail, notamment au moyen des figures annexes pour lesquelles :

- la figure 1 représente un schéma équivalent du principe de l'invention ;
- la figure 2 montre un schéma bloc du circuit ;
- la figure 3 donne un exemple de circuit électronique de traitement ;

- la figure 4 représente l'étage oscillateur ;
- la figure 5 donne la forme des signaux d'entrée et de sortie de l'oscillateur en fonction du temps ;
- la figure 6 illustre une possibilité de circuit pour un étage convertisseur fréquence / tension ;
- la figure 7 montre la forme du signal aux bornes de la capacité de sortie de cet étage ;
- la figure 8 représente le filtre passe-haut et l'amplificateur;
- la figure 9 donne la forme du signal en sortie dudit amplificateur ;
- la figure 10 illustre un circuit déclencheur monostable possible ; et
- la figure 11 montre la forme des signaux en sortie de l'étage de la figure 10, et la forme de la tension base-émetteur.

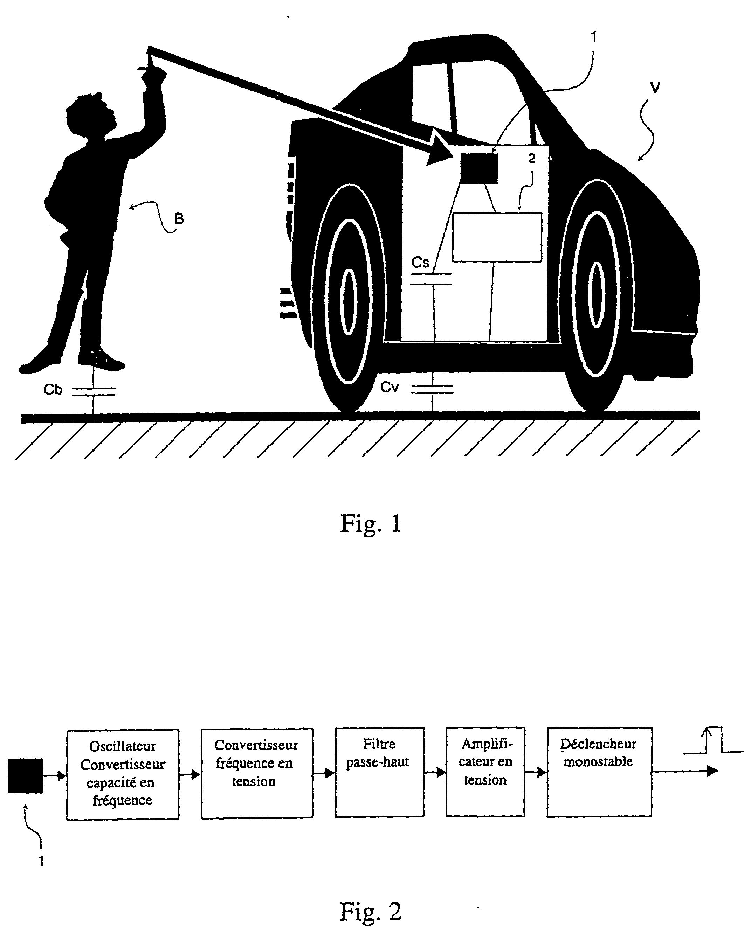

En référence à la figure 1, le véhicule (V) est représenté avec, sous le châssis, une connexion capacitive symbolisant la capacité électrique $C_v$ formée par le véhicule par rapport au sol. L'utilisateur (B) est également représenté avec une liaison capacitive $C_b$ symbolique par rapport au sol.

La plaquette (1) formant le capteur de charges électriques présente également une liaison capacitive $C_s$ avec la structure métallique du véhicule. Enfin, un circuit électronique de traitement (2) relié à ladite plaquette (1) traite l'information en provenance des capacités disposées en entrée selon le couplage évoqué ci-dessus, et répercute la variation de la capacité équivalente à l'adresse de la centrale électronique du véhicule, et notamment de l'émetteur-récepteur (non représenté) lié à ce dernier.

Le circuit de traitement (2) transforme la mesure de capacité d'entrée en un signal électrique de sortie sous forme d'une impulsion de durée fixe. L'objectif de l'invention est de détecter une variation relative de la capacité, et non pas une variation entre deux valeurs prédéterminées, ce qui élimine les problèmes liés à l'influence des variations de paramètres externes, tels que la température ou l'humidité, sur la valeur de la capacité "parasite" $C_s$ existant entre le capteur (1) et le véhicule (V).

De la même manière, cette mesure relative permet de ne pas se préoccuper de la qualité du contact entre le corps de l'utilisateur et la poignée de la portière, contact qui peut être altéré par la formation de poussière sur ladite poignée, l'existence de saletés sur les mains manipulant la poignée, etc...

Selon une mise en oeuvre possible, illustrée par la figure 2, la variation de capacité en entrée du circuit est transformée en une variation de fréquence par un oscillateur à haute fréquence (de 100 kHz à 2 MHz).

Ensuite, le signal passe par un étage convertisseur qui le convertit en une tension pour permettre d'effectuer des traitements analogiques du signal.

Un filtre passe-haut ou différentiateur supprime à l'étage suivant la composante continue du signal de tension, ce qui a pour effet d'empêcher la prise en compte des variations de capacité statiques dues à l'environnement.

Un amplificateur de tension augmente ensuite la sensibilité de la détection. Le gain de cet étage amplificateur est par exemple de 10, mais il peut être prévu supérieur à ce chiffre.

Enfin, un composant à seuil du type déclencheur monostable permet de transformer les variations positives ou négatives du signal en des impulsions carrées, créant un signal logique à deux états. Il est à noter que pour chaque impulsion, le front montant correspond au contact de la main sur la poignée de la portière.

Un tel circuit permet d'éviter les détections parasites causées par exemple par lesdites variations statiques de la capacité du capteur : seuls les contacts sur les poignées sont détectés. Il permet de plus d'opérer à courant faible, c'est-à-dire avec un courant inférieur à 2 mA pour une alimentation calée à 5V.

La détection offerte par ce système est très rapide, puisque le délai entre le contact et la détection électronique est de l'ordre de la milliseconde. La taille des composants électroniques est en outre très réduite, et l'ensemble peut être intégré à la poignée de la portière du véhicule. L'utilisation de circuits en MOS ou HCMOS conduit enfin à une fabrication peu onéreuse.

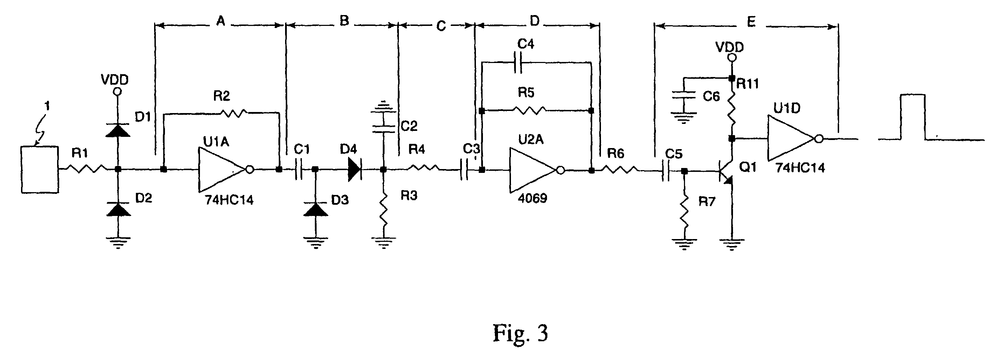

Un exemple d'un circuit de traitement possible est montré en figure 3 :

- Le convertisseur est fréquence est référencé A ;
- L'étage de transformation en un signal variable en tension apparaît enB;
- Le filtre passe-haut porte la référence C ;
- L'amplificateur de tension est signalé par D ; et
- Le déclencheur monostable de sortie est référencé E.

Il est à noter que des mesures ont été effectuées pour tester la viabilité du système de l'invention et notamment les hypothèses faites pour les différentes capacités impliquées dans le système. En pratique, la capacité $C_s$ de la plaquette-capteur (1) a été mesurée aux alentours de 6 à 7 pF.

Lorsque la main de utilisateur entre en contact avec le capteur (1), ou lorsqu'elle en est très proche, la capacité s'accroît jusqu'à atteindre 15 pF à 50 pF. Il s'agit là d'un accroissement substantiel qui garantit la bonne marche du système de l'invention.

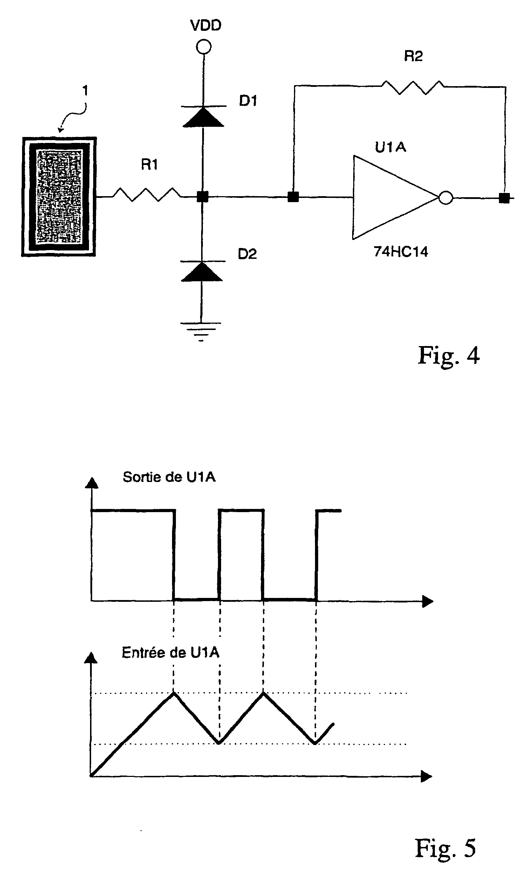

Les différents étages sont décrits en détail en référence aux figures 4 à 11.

Ainsi, les figures 4 et 5 concernent le convertisseur capacité / fréquence.

La plaque de détection (1) est connectée à l'entrée du convertisseur capacité / fréquence. Ce convertisseur utilise le principe de base d'un oscillateur à porte CMOS à hystérésis. Ce choix est avantageux en terme de coût et de disponibilité de ce type de composant dans les séries HCMOS : un circuit référencé 74 HC 14 pourra par exemple être utilisé.

La porte logique CMOS (U1A) est un inverseur logique à hystérésis. La résistance (R2) qui relie l'entrée à la sortie agit sur la réaction de l'oscillateur, de telle sorte que plus cette résistance (R2) diminue, plus la fréquence en sortie augmente, et inversement lorsqu'elle augmente, la fréquence diminue.

L'autre élément de cet oscillateur est bien entendu la plaque de détection (1) dont la capacité par rapport à la masse dépend à la fois de l'environnement et de la proximité du corps humain. Quand la sortie de la porte (U1A) est à l'état haut, la plaque capacitive (1) se charge à travers la résistance (R2) jusqu'à ce que la tension à l'entrée de la porte dépasse le seuil supérieur de l'hystérésis de basculement. À ce moment, la sortie passe à l'état bas et le phénomène inverse se produit : la plaque (1) se décharge à travers la résistance (R2) jusqu'à ce que la tension d'entrée de la porte soit inférieure au seuil de base de l'hystérésis, et la porte repasse à l'état haut. En sortie de la porte (U1A), on observe un signal carré (voir figure 5) dont la fréquence dépend de la capacité de la plaque (1). La variation de fréquence est linéaire en fonction de ladite capacité.

La valeur de la résistance (R2) est déterminée expérimentalement pour obtenir une fréquence supérieure à 100 kHz quand le corps humain ne touche pas la plaque de détection. Le courant d'alimentation consommé par cet oscillateur dépend fortement de la fréquence : un compromis sur le choix de la résistance (R2) permet de réduire le courant total du circuit à moins de 1 mA. Comme déjà mentionné, les diodes (D1, D2) et la résistance (R1) protègent l'entrée de la porte logique (U1A), notamment contre des surtensions et des décharges électrostatiques toujours possibles.

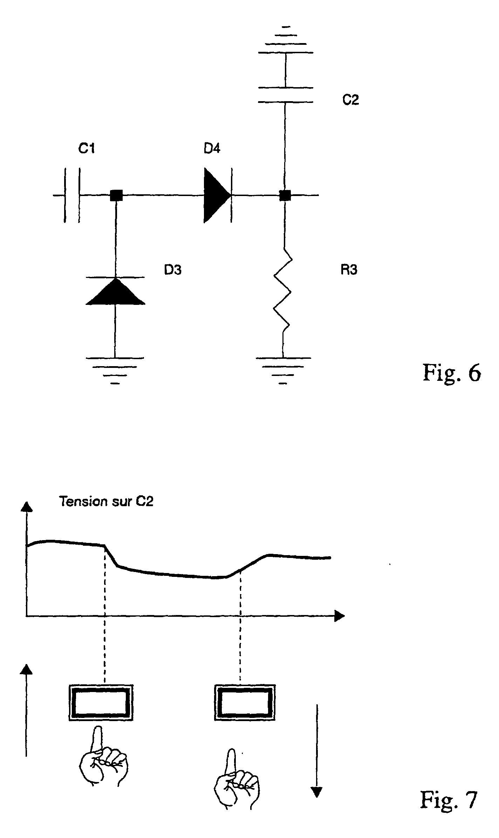

Le convertisseur fréquence / tension est montré en figure 6.

Le principe de ce convertisseur est basé sur la variation d'impédance d'un condensateur (C1) en fonction de la fréquence. L'impédance du condensateur (C1) est inversement proportionnelle à la fréquence puisqu'elle s'écrit $Zc = 1/(C\omega)$.

Les diodes (D4) et (D3) et la capacité (C2) constituent en fait un redresseur qui, associé à la capacité (C1), réalise la fonction de conversion de fréquence en tension. Si la fréquence baisse, l'impédance de la capacité (C1) augmente. La résistance dynamique des diodes forme de fait un diviseur de tension avec l'impédance de la capacité (C1), qui provoque une diminution de la tension redressée.

Le condensateur (C2) associé à la résistance (R3) filtre enfin la tension redressée avec une constante de temps de 100 μs, pour assurer une détection rapide, c'est-à-dire dans la milliseconde qui suit le contact de la main contre la plaque (1) de détection.

On retrouve aux bornes de la capacité (C2) une tension continue qui varie en fonction de la valeur de la capacité de la plaque détectrice (1), et qui est montrée en figure 7.

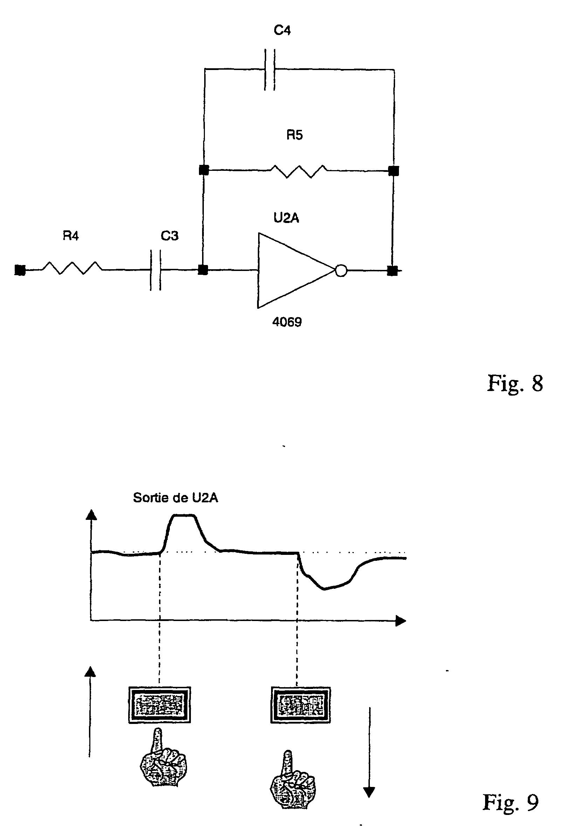

Le filtre passe-haut et l'amplificateur apparaissent en figure 8.

Pour que le capteur soit sensible aux variations statiques de capacité (salissures, température, humidité), un filtre passe-haut élimine les variations de tension continue en sortie du redresseur. Ce filtre est constitué de la capacité (C3), associée à la résistance (R4), qui détermine l'impédance d'entrée de l'amplificateur (U2A). Le rapport de (R4) à (R3) doit être d'au moins 5, et de préférence aux alentours de 10, pour ne pas influencer l'étage de filtrage constitué de la résistance (R3) et de la capacité (C2) situés en amont.

La constante de temps de la résistance (R4) multipliée par la valeur de l'impédance de la capacité (C3) est voisine de 100 ms. Elle agit sur la vitesse de déclenchement du capteur à l'approche de la main contre la plaque de détection. Plus la constante de temps est grande, plus le capteur est sensible à des variations lentes de la main.

L'amplificateur est l'un des maillons fondamentaux du circuit : il apporte un gain de tension stable en température et ne nécessite qu'un faible courant d'alimentation, de l'ordre de 100 μA. La porte logique (U2A) est une porte inverseuse type 4069 non "bufferisée" (qui ne comporte pas d'étage de puissance en sortie). Cette porte (U2A) associée à la résistance (R5) détermine le point de repos de la tension continue en sortie à la moitié de la tension d'alimentation. Cette structure apporte un gain de 10 en tension qui est déterminée par les résistances (R5) et (R4) (R5 = 10 R4).

La capacité (C4) diminue le gain aux fréquences élevées afin de réduire les perturbations transitoires rapides et les résidus de fréquence de l'oscillateur. La fréquence de coupure est déterminée par la constante de temps calculée à partir de l'impédance de la capacité (C4) et de la résistance (R4). Cette fréquence correspond environ à 1000 Hz et assure un temps de réponse du détecteur inférieur à la milliseconde.

La forme du signal de sortie de l'amplificateur (U2A) est montrée en figure 9. Ce signal montre une impulsion de tension positive quand on approche la main de la plaque (1) détectrice, et une impulsion négative quand on éloigne la main.

Cet effet de différentiation est dû au filtre passe-haut (voir précédemment) associé à l'amplificateur (U2A).

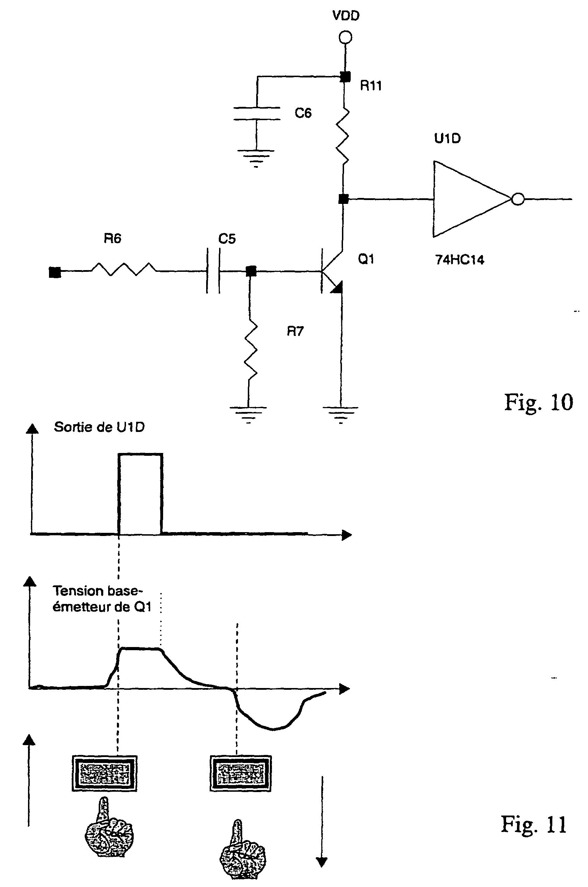

Le déclencheur monostable est représenté en figure 10. Il permet l'obtention d'une impulsion de durée fixée lorsque la main entre en contact avec la plaque détectrice (1). Ce déclencheur est constitué d'un transistor (Q1) associé à la capacité (C5). Une impulsion positive provenant de l'amplificateur (U2A) charge la capacité (C5) à travers la résistance (R6) qui a pour fonction de limiter le courant de charge. Ce dernier traverse la jonction base-émetteur du transistor (Q1) et la rend passante. La tension au collecteur du transistor (Q1) passe à zéro volt pendant que la tension base-émetteur est supérieure à 0,6 V environ. La durée de l'impulsion de sortie dépend de la valeur de la résistance (R6) et de la valeur de la capacité (C5). La résistance (R7) sert en fait à charger la capacité (C5) sur les parties négatives des impulsions délivrées par l'amplificateur (U2A). Le condensateur (C6) découple l'alimentation.

La porte logique CMOS (U1D) est un inverseur logique à hystérésis qui met en forme l'impulsion du transistor (Q1) à un niveau compatible avec les circuits logiques qui utilisent ce capteur. En sortie de la porte (U1D), on obtient une impulsion positive qui correspond uniquement au moment où la main entre en contact avec la plaque détectrice (1). Il n'y a pas d'impulsion lorsque la main quitte ladite plaque (1). C'est ce que montre la figure 11.

La description ci-dessus, et notamment les exemples fournis pour le circuit électronique de traitement, ne sont évidemment nullement exhaustifs de l'invention.

## Revendications

1. Dispositif de commutation fonctionnant par simple contact d'un corps humain, comportant un capteur capacitif (1) reflétant l'existence dudit contact, connecté à un circuit électronique de traitement (2) de la variation d'une grandeur électrique affectant ledit capteur (1), **caractérisé en ce que** le circuit de traitement (2) comporte successivement les étages suivants :

   - un oscillateur convertisseur (A) des variations de capacité en variations de fréquence ;
   - un convertisseur (B) convertissant les variations de fréquences en variations de tension ;
   - un filtre passe-haut (C) ou différentiateur ;
   - un amplificateur de tension (D) ; et
   - un déclencheur monostable (E) produisant un signal de sortie sous forme d'impulsions.

2. Dispositif de commutation selon la revendication précédente, **caractérisé en ce que** ledit capteur capacitif consiste en une plaquette métallique (1) disposée sur une structure capacitive dotée d'éléments pilotables par commutation.

3. Dispositif de commutation selon la revendication précédente, **caractérisé en ce que** la plaquette métallique (1) est isolée de ladite structure capacitive par une couche isolante d'épaisseur non négligeable, permettant de maintenir la capacité de la plaquette (1) par rapport à la structure à une valeur minimale.

4. Dispositif de commutation selon l'une des revendications 1 à 3, **caractérisé en ce que** l'oscillateur convertisseur (A) de capacité en fréquence est basé sur un inverseur logique (U1A) à hystérésis dont l'entrée et la sortie sont reliés par une résistance (R2) de réglage de la fréquence.

**5.** Dispositif de commutation selon la revendication précédente, **caractérisé en ce que** l'entrée de l'inverseur (U1A) et le capteur capacitif (1) sont reliés via une résistance (R1), ladite entrée étant en outre reliée à la tension d'alimentation (V$_{DD}$) et à la masse (G) via deux diodes de protection.

**6.** Dispositif de commutation selon l'une des revendications 3 à 5, **caractérisé en ce que** le convertisseur (B) fréquence / tension est constitué d'une première capacité (C1) de liaison, couplé à un redresseur comportant deux diodes (D3, D4) et une capacité (C2) de filtrage.

**7.** Dispositif de commutation selon la revendication précédente, **caractérisé en ce qu'**une résistance (R3) est disposée en parallèle à la capacité (C2).

**8.** Dispositif de commutation selon l'une quelconque des revendications 3 à 7, **caractérisé en ce que** le filtre passe-haut (C) est constitué d'une capacité (C3) connectée en série à une résistance (R4).

**9.** Dispositif de commutation selon la revendication précédente, **caractérisé en ce que** le rapport entre (R4) et (R3) est supérieur à 5.

**10.** Dispositif de commutation selon l'une quelconque des revendications 3 à 9, **caractérisé en ce que** l'amplificateur de tension (D) comporte une porte inverseuse (U2A) associée à une boucle de contre-réaction constituée d'une résistance (R5) et d'une capacité (C4) en parallèle.

**11.** Dispositif de commutation selon la revendication précédente, **caractérisé en ce que** le déclencheur monostable (E) est constitué d'un transistor (Q1) dont la base est connectée à une capacité (C5), et le collecteur est relié à un inverseur logique à hystérésis (U1D).

**12.** Dispositif de commutation selon la revendication précédente, **caractérisé en ce que** la sortie de l'amplificateur de tension (D) est reliée à la capacité (C5) via une résistance (R6).

**13.** Dispositif de commutation selon l'une des revendications 11 et 12, **caractérisé en ce qu'**une résistance (R7) est disposée en sortie de la capacité (C5), en parallèle à la jonction base-émetteur du transistor (Q1).

**14.** Dispositif de commutation selon l'une quelconque des revendications précédentes appliqué au verrouillage / déverrouillage d'au moins une des portes d'un véhicule (V).

**15.** Dispositif de commutation selon la revendication précédente, **caractérisé en ce que** le capteur (1) est constitué d'une plaquette métallique fixée au véhicule (V) au voisinage d'au moins un des mécanismes d'ouverture des portes.

**16.** Dispositif de commutation selon l'une des revendications 14 et 15, **caractérisé en ce que** le circuit électronique de traitement est connecté à un émetteur-récepteur lié au véhicule (V), émettant dès détection du contact un signal radiofréquence à destination d'un transpondeur manuel comportant un émetteur-récepteur, ledit transpondeur renvoyant à réception un signal d'identification autorisant la commande du système électronique de verrouillage / déverrouillage central des portes du véhicule (V).

**Patentansprüche**

**1.** Schaltvorrichtung, die durch einfachen Kontakt eines menschlichen Körpers funktioniert, umfassend einen kapazitiven Sensor (1), der das Vorhandensein des Kontakts wiedergibt, der zu einem elektronischen Verarbeitungschaltkreis (2) der Änderung einer elektrischen Größe verbunden ist, die den Sensor (1) beeinflusst, **dadurch gekennzeichnet, dass** der Verarbeitungs-Schaltkreis (2) sukzessive die folgenden Stufen umfasst:

einen Schwingungswandler (A) von Kapazitätsänderungen in Frequenzänderungen; einen Wandler (B), der die Frequenzänderungen in Spannungsänderungen umwandelt; einen Hochpaß-Filter (C ) oder Differentiator; einen Spannungsverstärker (D); und einen monostabilen Trigger (E), der ein Ausgangssignal in Form von Impulsen erzeugt.

**2.** Schaltvorrichtung gemäß dem vorhergehenden Anspruch, **dadurch gekennzeichnet, dass** der kapazitive Sensor aus einer metallischen Platte (1) besteht, die auf einer kapazitiven Struktur angeordnet ist, die mit Elementen dotiert ist, die durch Schaltung steuerbar sind.

**3.** Schaltvorrichtung gemäß dem vorhergehenden Anspruch, **dadurch gekennzeichnet, dass** die metallische Platte (1) von der kapazitiven Struktur durch eine Isolierschicht einer nicht vernachlässigbaren Dicke isoliert ist, die es erlaubt, die Kapazität der Platte (1) im Vergleich zu der Struktur auf einem minimalen Wert zu erhalten.

**4.** Schaltvorrichtung gemäß einem der Ansprüche 1 bis 3, **dadurch gekennzeichnet, dass** der Schwingungswandler (A) von Kapazität in Frequenz auf einem logischen Hysterese-Invertierer (U1A) basiert, von dem der Eingang und der Ausgang durch einen Frequenz-Steuerwiderstand (R2) verbunden sind.

5. Schaltvorrichtung gemäß dem vorhergehenden Anspruch, **dadurch gekennzeichnet, dass** der Eingang des Invertierers (U1A) und der kapazitive Sensor (1) über einen Widerstand (R1) verbunden sind, wobei der Eingang darüber hinaus zu der Versorgungsspannung ($V_{DD}$) und an die Masse (G) über zwei Schutzdioden verbunden ist.

6. Schaltvorrichtung gemäß einem der Ansprüche 3 bis 5, **dadurch gekennzeichnet, dass** der Frequenz-/Spannungs-Wandler (B) aus einer ersten Verbindungskapazität (C1) gebildet ist, die an einen Gleichrichter geschalten ist, umfassend zwei Dioden (D3, D4) und eine Filterkapazität (C2).

7. Schaltvorrichtung gemäß dem vorhergehenden Anspruch, **dadurch gekennzeichnet, dass** ein Widerstand (R3) parallel zu der Kapazität (C2) angeordnet ist.

8. Schaltvorrichtung gemäß irgendeinem der Ansprüche 3 bis 7, **dadurch gekennzeichnet, dass** der Hochpaß-Filter (C) aus einer Kapazität (C3) gebildet ist, die in Serie mit einem Widerstand (R4) geschalten ist.

9. Schaltvorrichtung gemäß dem vorhergehenden Anspruch, **dadurch gekennzeichnet, dass** das Verhältnis zwischen (R4) und (R3) größer als 5 ist.

10. Schaltvorrichtung gemäß irgendeinem der Ansprüche 3 bis 9, **dadurch gekennzeichnet, dass** der Spannungsverstärker (D) ein invertierendes Gatter (U2A) umfasst, das zu einer Gegenkopplungs-Schleife verbunden ist, die aus einem Widerstand (R5) und einer parallelen Kapazität (C4) gebildet ist.

11. Schaltvorrichtung gemäß dem vorhergehenden Anspruch, **dadurch gekennzeichnet, dass** der monostabile Trigger (E) aus einem Transistor (Q1) gebildet ist, von dem die Basis mit einer Kapazität (C5) verbunden ist, und wobei der Kollektor zu einem logischen Hysterese-Invertierer (UID) verbunden ist.

12. Schaltvorrichtung gemäß dem vorhergehenden Anspruch, **dadurch gekennzeichnet, dass** der Ausgang des Spannungsverstärkers (D) zu der Kapazität (C5) über einen Widerstand (R6) verbunden ist.

13. Schaltvorrichtung gemäß einem der Ansprüche 11 und 12, **dadurch gekennzeichnet, dass** ein Widerstand (R7) beim Ausgang der Kapazität (C5) angeordnet ist, parallel zum Basis-Emitter-Übergang des Transistors (Q1).

14. Schaltvorrichtung gemäß irgendeinem der vorhergehenden Ansprüche, die zum Versperren / Entsperren mindestens einer der Türen eines Fahrzeuges (V) angewandt wird.

15. Schaltvorrichtung gemäß dem vorhergehenden Anspruch, **dadurch gekennzeichnet, dass** der Sensor (1) aus einer metallischen Platte gebildet ist, die am Fahrzeug (V) fixiert ist, benachbart zu mindestens einem der Öffnungsmechanismen der Türen.

16. Schaltvorrichtung gemäß einem der Ansprüche 14 und 15, **dadurch gekennzeichnet, dass** der elektronische Verarbeitungsschaltkreis zu einem mit dem Fahrzeug (V) verbundenen Sender-Empfänger verbunden ist, der bei Kontakterfassung ein Radiofrequenz-Signal zu einem manuellen Transponder aussendet, der einen Sender-Empfänger umfasst, wobei der Transponder bei Empfang ein Identifikations-Signal zurücksendet, das zur Steuerung des elektronischen Systems des zentralen Versperrens / Entsperrens der Türen des Fahrzeugs (V) berechtigt.

## Claims

1. Switching device operated by simple contact with a human body, comprising a capacitive sensor (1) reflecting the existence of said contact, connected to an electronic circuit (2) for processing the variation in an electrical value affecting said sensor (1), **characterised in that** the processing circuit (2) incorporates the following stages in succession:

   - an oscillator (A) which converts variations in capacitance into variations in frequency;
   - a converter (B) which converts the variations in frequency into variations in voltage;
   - a high-pass filter (C) or differentiator;
   - a voltage amplifier (D); and
   - a monostable trigger (E) producing an output signal in the form of pulses.

2. Switching device as claimed in the preceding claim, **characterised in that** said capacitive sensor consists of a metal plate (1) disposed on a capacitive structure equipped with elements which can be controlled by switching.

3. Switching device as claimed in the preceding claim, **characterised in that** the metal plate (1) is isolated from said capacitive structure by an insulating layer of a not inconsiderable thickness, enabling the capacitance of the plate (1) to be maintained at a minimum value relative to the structure.

4. Switching device as claimed in one of claims 1 to 3, **characterised in that** the oscillator (A) which converts capacitance into frequency is based on a hysteresis logic inverter (U1A), the input and output of which are connected via a frequency-controlling resistor (R2).

5. Switching device as claimed in the preceding claim, **characterised in that** the input of the inverter (U1A) and the capacitive sensor (1) are connected via a resistor (R1), said input also being connected to the supply voltage ($V_{DD}$) and to ground (G) via two protection diodes.

6. Switching device as claimed in one of claims 3 to 5, **characterised in that** the frequency / voltage converter (B) is made up of a first linking capacitor (C1) coupled with a rectifier incorporating two diodes (D3, D4) and a filtering capacitor (C2).

7. Switching device as claimed in the preceding claim, **characterised in that** a resistor (R3) is disposed in parallel with the capacitor (C2).

8. Switching device as claimed in any one of claims 3 to 7, **characterised in that** the high-pass filter (C) is made up of a capacitor (C3) connected in series to a resistor (R4).

9. Switching device as claimed in the preceding claim, **characterised in that** the ratio between (R4) and (R3) is greater than 5.

10. Switching device as claimed in any one of claims 3 to 9, **characterised in that** the voltage amplifier (D) has an inverter gate (U2A) associated with a feedback loop comprising a resistor (R5) and a capacitor (C4) in parallel.

11. Switching device as claimed in the preceding claim, **characterised in that** the monostable trigger (E) comprises a transistor (Q1), the base of which is connected to a capacitor (C5) and the collector of which is connected to a hysteresis logic inverter (U1D).

12. Switching device as claimed in the preceding claim, **characterised in that** the output of the voltage amplifier (D) is connected to the capacitor (C5) via a resistor (R6) .

13. Switching device as claimed in one of claims 11 and 12, **characterised in that** a resistor (R7) is disposed at the output of the capacitor (C5), in parallel with the base-emitter junction of the transistor (Q1).

14. Switching device as claimed in any one of the preceding claims used as a means of locking / unlocking at least one of the doors of a vehicle (V).

15. Switching device as claimed in the preceding claim, **characterised in that** the sensor (1) is a metal plate fixed to the vehicle (V) in the vicinity of at least one of the opening mechanisms of the doors.

16. Switching device as claimed in one of claims 14 and 15, **characterised in that** the electronic processing circuit is connected to a transmitter-receiver linked to the vehicle (V) which, on detecting the contact, transmits a radio frequency signal addressed to a manual transponder incorporating a transmitter-receiver, which transponder returns an identification signal on reception, authorising control of the central electronic locking / unlocking system of the doors of the vehicle (V).

Fig. 1

Fig. 2

Fig. 3

VDD

1

D1

R2

R1

U1A

D2

74HC14

Fig. 4

Sortie de U1A

Entrée de U1A

Fig. 5

Fig. 6

Tension sur C2

Fig. 7

C4

R5

R4     C3     U2A

4069

Fig. 8

Sortie de U2A

Fig. 9

VDD

R11

C6

U1D

R6

C5

Q1

74HC14

R7

Fig. 10

Sortie de U1D

Tension base-
émetteur de Q1

Fig. 11